# EUROPÄISCHE PATENTSCHRIFT

(11) **EP 0 788 728 B1**
(45) Veröffentlichungstag und Bekanntmachung des Hinweises auf die Patenterteilung: **09.02.2000**
(21) Anmeldenummer: 95935819.3
(22) Anmeldetag: 18.10.1995
(51) Int. Cl.: H05K 3/18, H05K 3/24, C25D 5/02, G11C 17/14

(54) **VERFAHREN ZUM BESCHICHTEN ELEKTRISCH NICHTLEITENDER OBERFLÄCHEN MIT VERBUNDENEN METALLSTRUKTUREN**
PROCESS FOR COATING ELECTRICALLY NON-CONDUCTING SURFACES WITH CONNECTED METAL STRUCTURES
PROCEDE DE REVETEMENT DE SURFACES NON CONDUCTRICES ELECTRIQUEMENT AU MOYEN DE STRUCTURES METALLIQUES RACCORDEES

(30) Priorität: 18.10.1994 DE 4438799
(43) Veröffentlichungstag der Anmeldung: 13.08.1997
(73) Patentinhaber: ATOTECH Deutschland GmbH, 10553 Berlin (DE)
(72) Erfinder: MIDDEKE, Hermann-Josef, Dr., D-12247 Berlin (DE); TENBRINK, Detlef, D-13437 Berlin (DE)
(74) Vertreter: Effert, Bressel und Kollegen
(86) Internationale Anmeldenummer: DE9501502
(87) Internationale Veröffentlichungsnummer: WO9612393

(56) Entgegenhaltungen:
- EP-A- 0 153 683
- EP-A- 0 328 944
- BR-A- 9 105 585
- DE-A- 3 430 290
- US-A- 2 433 384
- US-A- 3 772 161
- PATENT ABSTRACTS OF JAPAN vol. 8 no. 30 (C-209) ,8.Februar 1984 & JP,A,58 193390 (MITSUBISHI RAYON KK) 11.November 1983,

## Beschreibung

Die Erfindung betrifft ein Verfahren zum Beschichten elektrisch nichtleitender Oberflächen mit Metallstrukturen.

Derartige Verfahren sind seit längerem bekannt. Beispielsweise werden mit einigen Verfahren zunächst ganzflächig erzeugte Metallschichten auf Nichtleiteroberflächen strukturiert. Diese Verfahren werden eingesetzt, wenn Metallstrukturen erzeugt werden sollen, um elektronische Baugruppen auf Trägerelementen leitend miteinander verbinden zu können. Dies dient insbesondere zur Herstellung von Leiterplatten für die Elektronik. Hierzu wird üblicherweise eine ganzflächige Metallschicht auf den Außenseiten und den durch Bohren erzeugten Lochwänden im Trägermaterial abgeschieden. Die ganzflächige Metallschicht wird anschließend mit einem Photoresist abgedeckt. Der Resist wird durch eine geeignete Maske belichtet und dann entwickelt. Beim sogenannten Positivverfahren werden die belichteten Resistschichten und im Negativverfahren die unbelichteten abgelöst. Auf den freigelegten Metalloberflächen wird danach weiteres Metall elektrolytisch abgeschieden. Anschließend kann der zurückgebliebene Resist von den Metalloberflächen vollständig entfernt werden. Leiterzüge werden dann dadurch gebildet, daß die dünne Basis-metallschicht zwischen den Strukturen in einem Ätzprozeß entfernt wird.

Die genannten Verfahren haben jedoch Nachteile, da, abhängig von der Schichtdicke der ersten ganzflächig aufgebrachten Metallschicht, die Randbereiche der Metallstrukturen beim Ätzen mehr oder weniger stark angegriffen werden, so daß sich unter Umständen durch Unterätzung der Metallstrukturen und Bildung galvanischer Elemente zwischen verschiedenen Metallen und dadurch hervorgerufenen ungleichmäßigen Angriff auf die Seitenflächen der Metallschichten keine randscharfen Metallstrukturen erzeugen lassen. Zum zweiten entstehen beim Ätzen umweltschädigende Lösungen, die aufwendig aufgearbeitet werden müssen. Außerdem sind aufwendige Vorrichtungen und sorgfältige Überwachung des Prozesses erforderlich.

In US-A-4,560,445 ist ein Verfahren zur Herstellung von Leiterbahnen auf einem dünnen Polyolefinfilmsubstrat, bei dem das Substrat nacheinander mit verschiedenen Vorbehandlungsbädern und einem Katalysatorbad behandelt und anschließend ein negatives Bild der zu erzeugenden Leiterbahnen mittels eines Resists gedruckt wird. Danach wird in den nicht mit Resist beschichteten Bereichen Metall erst stromlos und danach auch elektrolytisch abgeschieden. Die Leiterbahnen auf dem Substrat werden zur Herstellung eines resonanten Radiofrequenzschaltkreises gebildet, der in elektronischen Sicherheitssystemen und zur Überwachung von Kaufartikeln eingesetzt wird.

Eine Methode zur Herstellung von Leiterplatten gemäß EP-A-0 153 683 besteht darin, daß man Basisplatten mit der Lösung von Komplexverbindungen der Elemente der I. oder VIII. Nebengruppe des Periodensystems aktiviert, danach eine Resistauflage aufbringt und diese nach einem Resistmuster partiell belichtet, die abgedeckten Bereiche der Resistauflage mit einem Lösungsmittel herauslöst und die freigelegten Bereiche in einem naßchemischen Metallisierungsbad stromlos metallisiert.

In der Druckschrift EP 0 328 944 A2 wird ein Verfahren zum Konditionieren eines nichtleitenden Substrats für die nachfolgende selektive Abscheidung eines Metalles aus einem stromlosen Metallisierungsbad offenbart, wobei das nichtleitende Substrat an dessen Oberflächen zunächst aufgerauht, anschließend mit einer kolloidalen Dispersion von Palladium/Zinn-Partikeln behandelt wird, die Palladium/Zinn-Partikel durch Kontakt mit einer Alkalihydroxid-Lösung aktiviert werden, darauf ein permanenter photosensitiver Überzug laminiert und dieser anschließend mit einem Leiterbildmuster belichtet und entwickelt wird. Der Nachteil dieses Verfahrens besteht darin, daß die erzeugten Metallstrukturen ausschließlich durch stromlose Metallabscheidung gebildet werden. Dadurch ist eine sehr lange Behandlungszeit im stromlosen Metallisierungsbad erforderlich. Damit verbunden sind außerdem eine aufwendige Überwachung des Bades und außerordentlich umfangreiche und hohe Kosten verursachende Maßnahmen zur Aufarbeitung der entstehenden Abwässer. Es hat sich ferner herausgestellt, daß es außerordentlich schwierig ist zu vermeiden, daß sich Metall bei der stromlosen Abscheidung nicht nur auf den für die Metallstrukturen vorgesehenen Bereichen, sondern auch auf der Resistoberfläche abscheidet. Dieses als Wildwuchs bekannte Phänomen kann zu Kurzschlüssen zwischen einzelnen Metallstrukturen, beispielsweise Leiterzügen, führen.

Aus DE 35 10 982 A1 ist ein Verfahren zum Herstellen von elektrisch leitenden Strukturen auf Nichtleitern bekannt, bei dem unter anderem zunächst eine Kupferschicht mittels Glimmentladung auf die Nichtleiteroberfläche aufgebracht wird, die Nichtleiteroberfläche anschließend mit einem Photoresist beschichtet, dieser danach mit einem Leiterbahnbild belichtet und entwickelt wird. Im letzten Verfahrensschritt wird Kupfer aus einem chemisch reduktiven Kupferbad abgeschieden. Auch in diesem Fall muß der Nichtleiter lange in dem chemisch reduktiven Kupferbad behandelt werden, um die gewünschte Schichtdicke der Leiterbahnen zu erreichen. Ferner wird angegeben, daß die erste Metallisierung aus Kupfer nach dem Entfernen des Resistfilmes wieder entfernt, d.h. abgeätzt wird.

In WO-A 88/03668 ist ein Verfahren zum Metallisieren eines Substrats in einem vorbestimmten Muster offenbart. Hierzu wird zunächst ein Resist mit dem Muster auf die Substratoberflächen aufgebracht, dergestalt daß die vom Resist nicht bedeckten Bereiche der Substratoberfläche dem zu metallisierenden Muster entsprechen. Anschließend wird das Substrat mit einem Konditionierungsmittel behandelt, um die Adsorption von katalytisch wirksamen Spezies für die nachfolgende Metallisierung zu erhöhen. Danach wird das Substrat mit einem weiteren Hilfsstoff behandelt, um die Aufnahmefähigkeit der Resistoberflächen für die katalytischen Spezies zu erniedrigen. Danach werden die Oberflächen mit einem desaktivierenden Mittel behandelt und anschließend katalytisch aktiviert und stromlos metallisiert. Nach der Metallisierung wird der Resist vom Substrat wieder entfernt und weiteres Metall a f den erzeugten Leiterzugstrukturen abgeschieden. Die verschiedenen Behandlungsschritte zur Aktivierung und Desaktivierung der Oberflächen für die nachfolgende katalytische Behandlung dienen dazu, den Wildwuchs auf den Resistoberflächen zu vermeiden und die stromlose Abscheidung an den gewünschten Stellen nicht zu behindern.

Dieses Verfahren ist außerordentlich aufwendig. Um ausreichende Schichtdicken zu erreichen, ist in jedem Falle ein vollständiger Aufbau der Metallstrukturen durch stromlose Abscheidung erforderlich, so daß sich außerdem die bereits zuvor erwähnten Nachteile ergeben.

In EP 0 098 472 B1 ist ein Verfahren zum Reduzieren von Fehlstellen in plattiertem Metall offenbart, bei dem eine nicht-edle Metalloberfläche mit einer Schicht eines Edelmetalls beschichtet, darauf weiterhin eine photoleitfähige Schicht aufgebracht und diese dann mit dem gewünschten Muster belichtet und entwickelt wird. In den freiliegenden Bereichen wird anschließend ein Metall stromlos abgeschieden. Dieses Verfahren dient dazu, Metalloberflächen und nicht elektrisch nichtleitende Oberflächen mit Metallstrukturen zu versehen. Um elektrisch voneinander isolierte Metallstrukturen zu erhalten, muß die ganzflächige Grundmetallschicht, auf der die Metallstrukturen erzeugt worden sind, durch einen Ätzprozeß an den Stellen entfernt werden, an denen diese unerwünscht ist. Ferner sind die Metallstrukturen ausschließlich durch stromlose Abscheidung zu erzeugen, beispielsweise in Schichtdicken zwischen 25 µm und 50 µm. Dabei ergeben sich die zuvor genannten Nachteile.

In US-PS 48 10 333 ist ein Verfahren zum Abscheiden von Metall auf der Oberfläche eines Nichtleiters beschrieben, bei dem unter anderem auf den auf den Nichtleiteroberflächen gebildeten leitfähigen Sulfid-Konversionsschichten, die aus Palladium/Zinn-Schichten gebildet werden, eine Photoresistschicht gebildet und diese mit einem gewünschten Leiterbildmuster belichtet und entwickelt wird. Anschließend kann in den Bereichen in der Photoresistschicht, in denen die leitfähige Sulfid-Konversionsschicht freigelegt ist, Metall direkt elektrolytisch abgeschieden werden. Zur Bildung von Metallstrukturen muß die leitfähige Sulfid-Konversionsschicht jedoch zumindest teilweise in den Oberflächenbereichen wieder entfernt werden, in denen die einzelnen Metallstrukturen voneinander isolierend getrennt werden sollen, da sich andernfalls Kurzschlußbrücken zwischen den Metallstrukturen bilden würden. Aus diesem Grunde ist das Verfahren nur für bestimmte Anwendungen, vorzugsweise für die Herstellung von Leiterplatten, bei denen an den Außenseiten Kupferschichten als Kaschierung aufgebracht sind, geeignet. In diesem Fall werden die Leiterzugstrukturen ohnehin durch Ätzen der Kupferschichten an den Außenseiten gebildet, so daß die auf den Kupferschichten gebildete Sulfid-Konversionsschicht gleichzeitig entfernt wird.

In BR-A 9105585 ist ein Verfahren zur Herstellung von Zahlkarten für öffentliche Fernsprechapparate, bei dem auf ein nicht-durchlässiges, nicht-poröses Substrat eine ganzflächige erste leitfähige Schicht mit höherem Widerstand mit chemischen Methoden, vorzugsweise eine Nickelschicht mit max. 0,3 µm dikke, und danach eine 2 bis 8 µm dicke elektrolytisch ganzflächig abgeschiedene Metall- oder Legierungsschicht mit deutlich geringerem Widerstand und Schmelzpunkt als von der ersten Schicht, vorzugsweise eine Zinn/Blei-Schicht, abgeschieden wird. Bei der elektrolytischen Abscheidung sollen geringe Stromdichten von o,5 bis 2 A/dm² angewendet werden.

Der vorliegenden Erfindung liegt von daher das Problem zugrunde, ein Verfahren zu finden, mit dem die Nachteile des Standes der Technik behoben werden und mit dem es möglich ist, randscharfe Metallstrukturen auf den elektrisch nichtleitenden Oberflächen ohne Anwendung von Ätzprozessen zu erzeugen. Ein weiteres Problem besteht darin, eine Verwendung des Verfahrens zur Herstellung von Mitteln zur irreversiblen Informationsspeicherung, vorzugsweise von Automatenkarten zur elektronischen Abbuchung, zu finden.

Das Problem wird gelöst durch Anspruch 1. Bevorzugte Ausführungsformen der Erfindung sind in den Unteransprüchen angegeben.

Mit dem Verfahren ist es möglich, randscharfe Metallstrukturen auf den Oberflächen herzustellen, indem insbesondere nur eine erste dünne Metallschicht stromlos abgeschieden wird und dadurch, daß mittels der Maskentechnik miteinander verbundene Strukturen und anschließend die Metallstrukturen im wesentlichen auf elektrolytischem Wege erzeugt werden. Wildwuchsprobleme wie bei der stromlosen Abscheidung dicker Metallschichten entstehen dabei nicht.

Ein wesentlicher Vorteil des Verfahrens besteht darin, daß keine Ätzprozesse zur Bildung der Metallstrukturen benötigt werden. Damit entfallen zusätzliche Prozeßschritte, die Notwendigkeit der aufwendigen Überwachung eines Ätzprozesses, die Notwendigkeit, verbrauchte und verschleppte Lösungen aus dem Ätzprozeß aufzuarbeiten, und das Problem der Unterätzung und des ungleichmäßigen Angriffes des Ätzmittels auf die Flanken der Metallstrukturen. Auch dadurch können Metallstrukturen randscharf gebildet werden.

Ein weiterer Vorteil ergibt sich daraus, daß keine alkalischen Lösungen über längere Zeit hinweg mit den für die Strukturierung benötigten Resistbeschichtungen in Kontakt gebracht werden müssen. Um ausreichend leitfähige Strukturen bilden zu können, wäre es nämlich in der Regel üblich, diese aus einem alkalischen Formaldehyd enthaltenden Kupferbad abzuscheiden. Würde die gesamte Schichtdicke auf diese Weise gebildet, so würden die Resistschichten angegriffen werden. Durch Alkalien entwickel- und entfernbare Resistschichten könnten überhaupt nicht eingesetzt werden. Statt dessen müßten mit organischen Lösemitteln entwickel- und entfernbare Resistschichten verwendet werden. Diese sind jedoch aus abwasser- und ablufttechnischen Gründen möglichst zu vermeiden.

Schließlich ist es auch wesentlich einfacher, Metallschichten mit den geforderten metallphysikalischen Eigenschaften aus einem elektrolytischen als aus einem stromlosen Metallisierungsbad abzuscheiden. Meist sind die aus elektrolytischen Bädern abgeschiedenen Metallschichten duktiler und weitgehend frei von Verunreinigungen. Die Abscheidungsgeschwindigkeit aus elektrolytischen Bädern ist deutlich höher als aus stromlos abscheidenden Bädern. Außerdem bestehen bei stromlosen Bädern erhebliche Beschränkungen hinsichtlich der Art der abscheidbaren Metalle. Metalle wie Zinn und Blei können nur in sehr dünnen Schichten, Chrom überhaupt nicht stromlos abgeschieden werden. Die exakte Einhaltung der Legierungszusammensetzung bei der Abscheidung ist praktisch kaum möglich.

Eine bevorzugte Ausführungsform des erfindungsgemäßen Verfahrens besteht darin, daß ein Photoresist nach dem Abscheiden der zweiten Metallschicht wieder entfernt wird.

Als besonders geeignete Metalle werden als erste Metallschicht eine Nickelstromlos und als zweite eine Zinn/Blei-Legierungsschicht elektrolytisch abgeschieden, die möglichst niedrige Schmelzpunkte haben. Aus Gründen der Funktionssicherheit werden dabei für die zweite Schicht Metalle mit Schmelzpunkten unterhalb 350°C, zum Beispiel Blei, eingesetzt. Bei Nickel-Phosphor-Legierungen reduziert sich der Schmelzpunkt von über 1400°C für Nickel auf unter 900°C für die Legierung.

Die erste Metallschicht kann in einer Ausführungsform durch Reaktion der im stromlosen Metallisierungsbad enthaltenen Metallionen mit einem Reduktionsmittel, das an der zu beschichtenden Oberfläche adsorbiert ist, gebildet werden. In einer bevorzugten Variante wird als Reduktionsmittel die beim Katalysieren der Oberflächen mit einem Palladium/Zinn-Katalysator an der Oberfläche adsorbierten Zinn-(II)-Ionen in Form der Zinn-(II)-hydroxide genutzt und mittels dieses Reduktionsmittels Kupfer durch Reduktion von Kupferionen abgeschieden.

Die Metallstrukturen werden auf Oberflächen aus Acrylnitril-Butadien-Styrol-Copolymer (ABS) Polycarbonat, Polystyrol, Polyacryl- und Polymethacrylsäure und deren Ester insbesondere Polyvinylchloriden oder Epoxidharzen erzeugt. Jedoch können grundsätzlich auch andere Materialien mit dem Verfahren beschichtet werden, beispielsweise alle anorganischen oder organischen Substrate, wie Gläser, Keramiken und Polymere, Cyanatester, Polyimide, Polyamide, Polypropylen Fluorpolymere und andere.

Das Verfahren dient vor allem zur Herstellung von Mitteln zur irreversiblen Informationsspeicherung, vorzugsweise von Automatenkarten zur elektronischen Abbuchung, da es für diesen Anwendungsfall eine kostengünstige Verfahrensalternative darstellt.

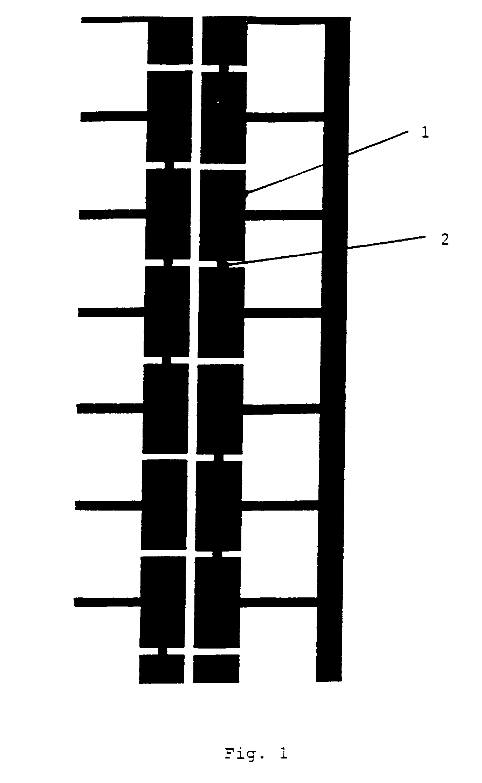

Hierzu werden Metallstrukturen nach dem in Fig. 1 dargestellten Muster auf einer ABS-Platte erzeugt. Zum Speichern und Lesen der gespeicherten Informationen auf den Automatenkarten, beispielsweise Telefonkarten, werden die Metallstrukturen auf der Karte induktiv angesprochen. Beim Speicher-/Lesevorgang ist ein Satz Primärspulen mit einer Spule über jedem Feld 1 der Metallstruktur angeordnet. Zum Speichern von Informationen wird durch eine Wechselspannung ein Magnetfeld in einzelnen Primärspulen und dadurch wiederum eine Wechselspannung in den einzelnen Feldern 1 induziert. Sind einzelne Felder 1 durch die Brücken 2 kurzgeschlossen, so steigt der Strom in den Primärspulen zum Erzeugen des Magnetfeldes an. Ist keine Brücke 2 vorhanden, so ist der Strom in den Primärspulen niedrig.

Zum Ändern der gespeicherten Informationen muß die jeweilige Brücke 2 zerstört werden, so daß die Felder 1 voneinander getrennt werden. Dazu wird lediglich die Wechselspannung in der Primärspule kurzzeitig erhöht.

Üblicherweise müssen die Nichtleiteroberflächen mit geeigneten Mitteln vorbehandelt werden, um eine ausreichende Haftfestigkeit zwischen den Metallstrukturen und der Oberfläche zu gewährleisten. Dies kann im wesentlichen durch eine Reinigung und mechanische oder chemische Aufrauhung der Oberflächen geschehen. Dabei werden die Oberflächen in der Regel hydrophilisiert, d.h. mit Wasser benetzbar gemacht. Ferner können auch chemische funktionelle Gruppen in der Oberfläche durch gezielte chemische Reaktionen modifiziert werden. Als Reinigungslösungen werden Netzmittel enthaltende wäßrige Lösungen verwendet. Die Reinigungswirkung wird insbesondere durch mechanische Bewegung der Behandlungslösung unterstützt. Besonders wirkungsvoll ist die zusätzliche Anwendung von Ultraschall. Zum chemischen Aufrauhen der Oberflächen können unterschiedliche Verfahren eingesetzt werden, die an die jeweiligen Materialien der Nichtleiter angepaßt sind. Für ABS-Polymere und Epoxidharze haben sich insbesondere chromsäurehaltige Lösungen, wie beispielsweise Chromschwefelsäure, als besonders geeignet erwiesen. Es ist auch möglich, alkalische Permanganatlösungen, diese in Verbindung mit organischen Quellösungen, konzentrierte Schwefelsäure und, im Falle von Polyamiden, alkalische Lösungen von organischen Lösemitteln einzusetzen.

Nach der Vorbehandlung der Nichtleiteroberflächen werden diese mit einer für die stromlose Abscheidung von Metallen katalytischen Schicht beschichtet. Es sind sowohl ionische als auch kolloidale Katalysatorsysteme bekannt. Meist wird Palladium als katalytisch aktives Metall verwendet. Kupfer eignet sich nur begrenzt, da es nur eine geringe katalytische Aktivität aufweist. Als ionische Katalysatoren werden beispielsweise Lösungen mit mit Komplexliganden komplexierten Palladiumionen verwendet. Die kolloidalen Systeme enthalten Palladium in der Oxidationsstufe Null und als Schutzkolloid entweder eine organische Verbindung, wie beispielsweise Polyvinylalkohol, oder Zinn-(II)-hydroxide. Die letztgenannten Katalysatoren werden durch Zusammengeben von Palladiumchlorid und Zinn-(II)-chlorid in salzsaurer Lösung und anschließendes Erwärmen gebildet.

Danach werden die miteinander verbundenen Strukturen auf einer oder mehreren katalysierten Oberflächen des beispielsweise plattenförmigen Substrats mittels einer Maskentechnik erzeugt. Dies geschieht mit Photoresisten. Es können im Positivverfahren und im Negativverfahren arbeitende Photoresiste eingesetzt werden. Die Photoresiste werden nach dem Aufbringen, beispielsweise durch Tauchen oder Laminieren, durch eine Bildvorlage hindurch belichtet, um ein latentes Bild im Resist zu bilden. Anschließend wird dieses latente Bild in geeigneten Lösungen entwickelt. Die den späteren Metallstrukturen entsprechenden Bereiche werden beim Entwicklungsprozeß von der Nichtleiteroberfläche abgelöst. Dadurch wird die Oberfläche mit der darauf befindlichen katalytischen Schicht freigelegt.

Anschließend wird eine dünne, beispielsweise maximal 3 µm, vorzugsweise 0,01 bis 1,0 µm dicke, erste Metallschicht ausschließlich auf den Bereichen abgeschieden, in denen die katalytisch aktive Schicht freigelegt wurde. In den übrigen Bereichen wird kein Metall abgeschieden. Als stromlos abscheidbare Metalle kommen Nickel, Kupfer, Gold, Palladium und Kobalt in Betracht. Es werden solche Bäder genommen, die nicht alkalisch sind, da in diesem Fall Photoresistmaterialien benutzt werden können, die in alkalischen Lösungen entwickel- und entfernbar sind.

Meist werden hierzu Bäder eingesetzt, aus denen das Metall durch Reduktion mittels in dem Bad enthaltener Reduktionsmittel abgeschieden wird. Beispielsweise kann Kupfer aus Formaldehyd enthaltenden alkalischen, aber auch aus Hypophosphit enthaltenden sauren oder neutralen Bädern abgeschieden werden. Auch Borhydrid-Verbindungen, beispielsweise Natriumborhydrid und Dimethylaminoboran enthaltende Kupferbäder sind bekannt. Nickel und Kobalt sowie deren Legierungen werden aus Hypophosphit enthaltenden Lösungen abgeschieden. In diesem Fall entstehen Phosphorlegierungen. Wird Hydrazin als Reduktionsmittel eingesetzt, können die reinen Metalle niedergeschlagen werden. Mit Borhydrid-Verbindungen werden Borlegierungen der Metalle erhalten. Edelmetalle werden vorzugsweise aus Borhydrid enthaltenden Bädern abgeschieden. Zur Abscheidung von Palladium sind auch Ameisensäure und Formiate enthaltende Lösungen bekannt. Bevorzugt werden niedriger schmelzende Legierungen, beispielsweise Nickel-Phosphor-Legierungen in dünner Schicht verwendet.

Eine andere Möglichkeit zur stromlosen Abscheidung der Metalle besteht darin, daß das Reduktionsmittel auf der zu beschichtenden Oberfläche adsorbiert ist und mit den Metallionen des stromlosen Bades reagiert. Beispielsweise können hierzu die in einem Palladium/Zinn-Katalysator enthaltenen Zinn-(II)-Ionen, die an der Oberfläche als Zinn-(II)-hydroxide vorliegen, verwendet werden.

Nach der Erzeugung einer ersten, dünnen, leitfähigen Metallschicht kann diese durch weitere elektrolytische Metallisierung verstärkt werden. Die erwünschte Schichtdicke von3 bis 50 µm wird durch elektrolytische Metallabscheidung erreicht. Dadurch daß beim stromlosen Metallisieren auf den Resistoberflächen kein Metall niedergeschlagen worden ist, kann im elektrolytischen Bad an diesen Stellen auch kein Metall abgeschieden werden. Die Metallstrukturen werden schnell und mit guten metallphysikalischen Eigenschaften gebildet. Abscheidbare Metalle sind Kupfer, Nickel, Zinn, Blei, Gold, Silber, Palladium und andere Metalle sowie Legierungen dieser Metalle.

Danach kann die Photoresistschicht entfernt werden. Hierzu wird je nach Resisttyp eine wäßrige, alkalische Lösung oder eine Lösung organischer Lösemittel verwendet.

Es versteht sich von selbst, daß zwischen den einzelnen Prozeßstufen weitere Verfahrensschritte angewendet werden, wie beispielsweise Spülvorgänge, Reinigungs-, Konditionier- und Ätzschritte sowie Erwärmungen des Substrats.

Die nachfolgenden Beispiele dienen der Erläuterung der Erfindung.

### Beispiel 1:

Ein plattenförmiges ABS-Substrat mit einer Dicke von 350 µm und einer Fläche von 45 cm x 60 cm (18 inch x 24 inch) wurde 10 Minuten lang in einer Lösung aus 360 g/l Schwefelsäure und 360 g/l Chrom-(VI)-oxid gebeizt. Nach dem Abspülen überschüssiger Säure wurden noch anhaftende Reste von Chrom-(VI)-Ionen durch einminütiges Tauchen in 2 Gew.-%iger Natriumhydrogensulfid-Lösung reduziert. Das nun gereinigte, hydrophile und mikrorauhe Substrat wurde 1 Minute lang in 30 Gew.-%ige Salzsäure-Lösung getaucht, gespült und danach 3 Minuten lang in eine Lösung, gebildet aus 250 mg/l Palladiumchlorid, 340 g/l Zinn(II)-chlorid und 250 g/l Natriumchlorid (Palladium-Kolloid mit Zinn(II)-hydroxid als Schutzkolloid). Dadurch wurden katalytisch wirksame Palladiumcluster auf der Oberfläche erzeugt. Überschüssige Behandlungslösung wurde danach durch Abspülen von der Oberfläche entfernt. Anschließend wurde gebildetes kolloidales Zinnhydroxid durch 2 Minuten langes Tauchen in einer Lösung aus organischen Säuren (Citronensäure, Oxalsäure) von der Substratoberfläche abgelöst. Das Substrat wurde wiederum gespült und getrocknet.

An diese Vorbehandlung schloß sich die Bildübertragung an: Das Substrat wurde beidseitig bei 105 °C mit einem handelsüblichen Photoresist (beispielsweise Laminar HG 1.5 MIL von Morton International GmbH, Dietzenbach, DE) durch Laminieren beschichtet und auf einer Seite durch eine geeignete Maske (Fig. 1 ) belichtet (45 mJoule/cm² bei 365 nm). Nach dem Entfernen der Schutzfolie vom Photoresist wurde dieser mit 1 Gew.%-iger Natriumcarbonat-Lösung in üblicher Weise entwickelt. Die nun freiliegende katalysierte Substratoberfläche wurde durch Eintauchen in ein stromlos abscheidendes Nickelbad mit Hypophosphit als Reduktionsmittel bei 45 °C innerhalb von 3 Minuten mit einer Nickel/Phosphor-Legierungsschicht belegt (pH-Wert etwa 7). Danach wurde überschüssiger Nickelelektrolyt abgespült. Anschließend wurde innerhalb von 8 Minuten eine Schicht einer Zinn/Blei-Legierung bei einer Stromdichte von 3 A/dm² aus einem Methansulfonsäure enthaltenden Zinn/Blei-Elektrolyten elektrolytisch abgeschieden. Die abgeschiedene Schichtdicke betrug 8 µm.

Die auf der einen Seite der ABS-Platte hergestellten Metallstrukturen gemäß dem in Figur 1 dargestellten Muster dienen der irreversiblen Informationsspeicherung. Informationen können durch Zerstörung der schmalen Zinn/BleiBrücken 2 durch induktive Erhitzung gespeichert werden. Die Anzahl der zerstörten und der noch nicht zerstörten Brücken können ebenfalls durch Induktionsmessung bestimmt werden.

### Beispiel 2:

Eine 0,3 mm dicke ABS-Folie wurde zunächst innerhalb von 2 Minuten in einem alkalischen Reiniger bei 60 °C von Staub und Fingerabdrücken befreit. Nach dem Abspülen von Reinigerresten von den ABS-Folienoberflächen wurde die Folie in einer wäßrigen Lösung von Ethylenglykol-Derivaten (Queller Covertron, Atotech Deutschland GmbH, Berlin, DE) 9 Minuten lang bei Raumtemperatur angequollen. Die Oberflächen wurden anschließend 6 Minuten lang in einer wäßrigen Lösung aus 140 g/l Natriumpermanganat und 50 g/l Natriumhydroxid bei 60 °C behandelt und dabei hydrophilisiert und aufgerauht. An den Oberflächen entstandenes Manganoxid (Braunstein) wurde danach durch Reduktion entfernt. Als Reduktionsmittel wurde eine wäßrige Lösung von Wasserstoffperoxid und Schwefelsäure verwendet.

Analog zu Beispiel 1 wurde die ABS-Folie anschließend katalysiert und getrocknet (Umlufttrocknung: 10 Minuten bei 50 °C). Danach wurde auf beide Seiten der Folie ein Photoresist laminiert (Riston 4615, Warenzeichen von DuPont de Nemours, Inc., Wilmington, Del., USA; Laminiertemperatur 115 °C, Laminiergeschwindigkeit 1 m/min). Der Resist wurde durch eine geeignete Bildvorlage hindurch belichtet (60 mJoule/cm² bei 365 nm) und anschließend wie in Beispiel 1 entwickelt.

Analog zum vorangehenden Beispiel wurden dann die freiliegenden katalysierten ABS-Oberflächen 5 Minuten lang mittels einem stromlos abscheidenden Nickelbad mit Hypophosphit als Reduktionsmittel (Nichem 6100 AF, Atotech Deutschland GmbH, DE) bei 45 °C und pH 7 mit einer Nickel/Phosphor-Legierungsschicht überzogen. Anschließend wurde ebenfalls analog Beispiel 1 eine 8 µm dicke Zinn/Blei-Legierungsschicht abgeschieden (Behandlungszeit 5 Minuten, Temperatur 22 °C, Stromdichte 4 A/dm²).

### Beispiel 3:

Eine 0,25 mm dicke PVC-Folie wurde in einer Bürstmaschine aufgerauht. Die Oberfläche wurde anschließend von Verunreinigungen durch Abspülen befreit. Danach wurden die Oberflächen durch Eintauchen in eine wäßrige Lösung eines quaternisierten Polyamins (Konzentration 6 g/l) 5 Minuten lang bei 45 °C konditioniert. Nach kurzem Eintauchen in eine Vortauchlösung, enthaltend 250 g/l Natriumchlorid und 7 ml/l konzentrierte Salzsäure, wurden die Oberflächen in einem Katalysator aus kolloidalem Palladium (Konzentration 250 mg/l), Zinn(II)-Chlorid (Konzentration 340 g/l) und Natriumchlorid (Konzentration 250 g/l) 4 Minuten lang bei 45 °C katalysiert. Im Anschluß an diese Behandlung wurden die Oberflächen in einer wäßrigen Lösung, enthaltend 15 g/l Weinsäure, 4 g/l Kupfersulfat und 1 mol/l Alkalihydroxid, 2 Minuten lang behandelt. Hierbei wurden die an der Oberfläche adsorbierten Zinnverbindungen wieder entfernt. Dabei wurde Kupfer stromlos abgeschieden. Danach wurden die Oberflächen erneut gespült und 10 Minuten lang bei 45 °C getrocknet.

Anschließend wurde ein flüssiger Positivresist (Ozatec PL 177, Warenzeichen der Morton International GmbH, Dietzenbach) durch Tauchen auf die Oberflächen aufgebracht (Laminiergeschwindigkeit 40 cm/min). Danach wurde der Resist 10 Minuten lang bei 80 °C getrocknet. Durch eine geeignete Bildvorlage hindurch wurde die Resistschicht mit Licht mit einer Wellenlänge von 365 nm und einer Leistung von 90 mJoule/cm² belichtet und wie üblich entwickelt. Die Oberflächen wurden dann in der schon in den Beispielen 1 und 2 beschriebenen Weise mit einer Zinn/Blei-Schicht versehen.

## Patentansprüche

1. Verfahren zur Herstellung von randscharfen und haftfesten Metallstrukturen, bestehend aus im wesentlichen nebeneinander angeordneten Feldern und diese kurzschließenden Brücken, aus einer auf einem Substrat mit nichtleitenden Oberflächen aus Acrylnitril-Butadien-Styrol-Copolymer, Polycarbonat, Polystyrol, Polyacryl- oder Polymethacrylsäure oder deren Estern aufgebrachten ersten Metallschicht aus einer Nickel/Phosphor-, einer Kobalt/Phosphor-, einer Nickel Bor- oder einer Kobalt/Bor-Legierung oder einer Legierung von Nickel und Kobalt mit Phosphor oder Bor und einer darauf aufgebrachten zweiten, bei Temperaturen unterhalb 350 °C schmelzenden, Eutektika bildenden Legierungsmetallschicht zur Herstellung von Mitteln zur irreversiblen Informationsspeicherung, ohne Anwendung von Metallätzprozessen mit den wesentlichen Verfahrensschritten:
a. Aufbringen eines für die stromlose Abscheidung von Metallen geeigneten Katalysators aus einer wäßrigen Lösung,
b. danach Bilden eines Musters als Abbild der miteinander verbundenen Strukturen auf den Oberflächen mittels alkalisch entwickel- und entfernbarer Photoresiste,
c. danach stromlos Abscheiden der ersten dünnen Metallschicht auf nach und durch Strukturierung freigelegten katalytisch beschichteten Oberflächenbereichen mittels eines Abscheidebades mit einem pH-Wert im neutralen oder sauren Bereich und mit einer Hypophosphitverbindung oder einer Borhydridverbindung als Reduktionsmittel,
d. danach elektrolytisch Abscheiden der zweiten Metallschicht auf der ersten Metallschicht.

2. Verfahren nach Anspruch 1, dadurch gekennzeichnet, daß die Photoresiste nach dem Abscheiden der zweiten Metallschicht wieder entfernt werden.

3. Verfahren nach einem der vorstehenden Ansprüche, dadurch gekennzeichnet, daß als zweite Metallschicht eine Zinn/Blei-Legierungsschicht abgeschieden wird.

4. Verwendung des Verfahrens nach einem der vorstehenden Ansprüche zur Herstellung von Automatenkarten zur elektronischen Abbuchung.

## Claims

1. Method of producing sharp-edged and strongly bonded metal structures formed from fields, which are disposed substantially adjacent one another, and from bridges, which short-circuit said fields, from a first metal layer, which is applied to a substrate having non-conductive surfaces formed from acrylonitrile-butadienestyrene copolymer, polycarbonate, polystyrene, polyacrylic or polymethacrylic acid or esters thereof, and which first layer is formed from a nickel/phosphorus alloy, a cobalt/phosphorus alloy, a nickel/boron alloy or a cobalt/boron alloy or an alloy of nickel and cobalt with phosphorus or boron, and from a second alloy metal layer, which is applied thereto, which melts at temperatures below 350° C and forms eutectic mixtures, to produce means for the irreversible storage of data without the use of metal etching processes, having the essential method steps:
a. applying a catalyst, suitable for the currentless deposition of metals, from an aqueous solution;
b. then forming a pattern as an image of the interconnected structures on the surfaces by means of alkalinely developable and removable photoresists;
c. then currentlessly depositing the first thin metal layer on catlytically coated surface regions, which are exposed after and by structuring, by means of a deposition bath having a pH value in the neutral or acidic range and having a hypophosphite compound or a boron hydride compound as the reducing agent; and
d. then electrolytically depositing the second metal layer on the first metal layer.

2. Method according to claim 1, characterised in that the photoresists are removed after the deposition of the second metal layer.

3. Method according to one of the preceding claims, characterised in that a tin/lead alloy layer is deposited as the second metal layer.

4. Use of the method according to one of the preceding claims to produce automatic machine cards for electronic debiting purposes.

## Revendications

1. Procédé pour fabriquer des structures métalliques nettes aux bords et adhésives, composées de champs disposés essentiellement côte à côte et de ponts qui les mettent en court-circuit, à partir d'une première couche métallique appliquée sur un substrat avec des surfaces non-conductrices en ABS, polycarbonate, polystyrène, acide polyacrylique ou polyméthacrylique ou leurs esters, couche composée d'un alliage nickel/ phosphore, cobalt/ phosphore, nickel/ bore ou cobalt/ bore ou d'un alliage de nickel et de cobalt avec du phosphore ou du bore, et à partir d'une deuxième couche métallique d'alliage appliquée sur celle-ci, qui fond à des températures inférieures à 550°C et forme des systèmes eutectiques, pour fabriquer des moyens destinés à un stockage d'informations irréversible, sans utiliser des processus de gravure sur métal, comprenant les étapes de procédé essentielles consistant à :
a) appliquer un catalyseur adapté pour déposer sans courant des métaux à partir d'une solution aqueuse,
b) ensuite, former un dessin en tant que reproduction des structures mutuellement reliées sur les surfaces au moyen de photorésists pouvant être développés et éliminés de façon alcaline,
c) ensuite, déposer sans courant la première couche métallique fine sur des zones superficielles couvertes par catalyse, exposées après et par structuration, au moyen d'un bain de dépôt avec une valeur de pH dans le domaine neutre ou acide et avec un composé d'hypophosphite ou un composé de borane comme agent de réduction,
d) ensuite, déposer par électrolyse la deuxième couche métallique sur la première couche métallique.

2. Procédé selon la revendication 1, caractérisé en ce que les photorésists sont à nouveau éliminés après le dépôt de la deuxième couche métallique.

3. Procédé selon l'une quelconque des revendications précédentes, caractérisé en ce que comme deuxième couche métallique, une couche d'alliage étain/ plomb est déposée.

4. Utilisation du procédé selon l'une quelconque des revendications précédentes pour fabriquer des cartes de distributeur automatique pour un débit électronique.
